# EUROPEAN PATENT APPLICATION

(11) **EP 4 258 515 A1**
(43) Date of publication of application: **11.10.2023**
(21) Application number: 22305448.7
(22) Date of filing: 04.04.2022
(51) Int. Cl.: H02J 15/00, H01F 6/00

(54) **SUPERCONDUCTING ENERGY STORAGE DEVICE**

(71) Applicant: Renaissance Fusion, 38600 Fontaine (FR)
(72) Inventor: VOLPE, Francesco, 38600 FONTAINE (FR)
(74) Representative: Cabinet Beaumont

(57) **Abstract**

The present disclosure relates to an energy storage device comprising:
- at least one superconducting sheet (1) adapted to be coupled to a load in a discharge mode and/or to an energy source in a charge mode, wherein each superconducting sheet comprises a superconducting layer, and at least a groove (104) extending from a first surface (116) of said superconducting sheet into at least the superconducting layer, the pattern of the groove being a space-filling curve; and
- at least one electrode (102), preferably two electrodes, for each superconducting sheet, the at least one electrode being coupled to the groove of said superconducting sheet, for example one electrode at each end of the space-filling curve pattern of the groove.

## Description

### Technical field

Disclosed herein is a superconducting energy storage device. One as such may be included in the field of energy storage devices. Specifically, the energy storage device disclosed is related to devices that store electromagnetic energy and includes a superconducting component.

### Background art

The demand for novel systems that allow for not only distribution and generation of power, but also storage of the produced energy has increased over the years. As the costs of available resources like fossil fuels and nuclear deposits increase year by year, industries have looked for new solutions that include reducing wasted energy and storing excess energy. Energy storage methods and devices that implement them are a solution to a convening energy crisis which reduces costs and provides for energy distribution at different scales. Energy storage is not only limited to perishable resources but is also an enticing alternative for overgeneration of energy from renewable sources which depend on weather conditions like water, sunlight or wind; for instance, a hydroelectric power plant could store excess energy produced during the rainy seasons and use it during the dryer summer months.

Energy storage devices store energy in a certain form for it to be used, be it in the same or a different form, at a later date. A battery, for example, is an energy storage device that stores chemical energy which is posteriorly used in the form of electrical energy; a spring stores potential energy which may later be recovered as mechanical energy. An energy storage device like a battery or a spring is limited in its usability because the material it is comprised of eventually cedes; batteries lose their charge and springs break after enough time has passed. Overcoming these limitations has motivated the study of alternatives based on materials or methods without losses or decay and that may last for an indefinite, or at least very long, amount of time.

Energy storage devices based on principles of electromagnetism aim to provide one such alternative. In magnetic energy storage devices, energy is stored as the electromagnetic field of a current. If said current is being carried by a superconducting coil, then that current would undergo no energy losses during discharge. It is known in the state of the art that devices with high impedance are preferred, with greater impedance resulting in better energy storage capabilities. To the best knowledge of the inventors, no device or method that would store energy in a current carrying coil without involving a significant magnetic field is known to exist in the state of the art.

A search for prior art related to the technique discovered U.S. Pat. No. 5,289,150 to Rabinowitz, a document which discloses the known techniques regarding superconducting magnetic energy storage, or SMES. Rabinowitz discloses an apparatus and method for trapping an electromagnetic field and using said method for storing energy. This apparatus includes a superconducting coil but fails to disclose a way for which energy storage could be achieved without a substantial magnetic field.

Another component of a superconducting magnetic energy storage device is a superconducting coil. A review of the prior art found several documents dealing with the construction of such coils. One such document is U.S. Pat. No. 9,812,233 to Sazaki, et. al., which describes the current state of the art concerning the construction of superconducting material films, also described as tapes. The current state of the art considers producing tapes which are stacked to form a cable like structure. This cable like structure is then shaped according to the needs of the application. It may be cut to shape, twisted, stacked or otherwise.

### Summary of Invention

One embodiment addresses all or some of the drawbacks of known energy storage devices.

One embodiment provides an energy storage device comprising:
- at least one superconducting sheet adapted to be coupled to a load in a discharge mode and/or to an energy source in a charge mode, wherein each superconducting sheet comprises a superconducting layer, and at least a groove extending from a first surface of said superconducting sheet into at least the superconducting layer, the pattern of the groove being a space-filling curve; and
- at least one electrode, preferably two electrodes, for each superconducting sheet, the at least one electrode being coupled to the groove of said superconducting sheet, for example one electrode at each end of the space-filling curve pattern of the groove.

In one embodiment, the groove separates the superconducting sheet into different electrically conductive regions.

In one embodiment, the device further comprises a cooling agent adapted to cool the at least one superconducting sheet, the cooling agent being for example liquid nitrogen or helium.

In one embodiment, the device further comprises an electrical terminal adapted to couple the at least one superconducting sheet through the at least one electrode to a load and/or to an energy source, for example using a switch.

In one embodiment, the device further comprises:
- a rack adapted to hold the at least one superconducting sheet, for example by means of at least one holding element sustained by a structural element, each holding element being adapted to support a superconducting sheet; and
- a container adapted to house the rack, the container being adapted to be thermally insulated; and, possibly
- a servicing device adapted to servicing a cooling agent, the servicing device being for example located on a surface of the container; and/or
- a pressure relief valve, for example located on a surface of the container.

In one embodiment, the device comprises a plurality of superconducting sheets, wherein the at least one electrode is coupled to an electrical switching device using a series and/or parallel connection.

In one embodiment, the device comprises a plurality of superconducting sheets, wherein the at least one electrode for each superconducting sheet comprises a first electrode and a second electrode, for example the first electrode at a first end and the second electrode at a second end of the space-filling curve pattern of the groove of said each superconducting sheet.

In one particular embodiment, the first electrodes of the plurality of superconducting sheets are coupled in parallel to the electrical switching device, and the second electrodes of the plurality of superconducting sheets are coupled in series to a common connection point which is coupled to the electrical switching device.

In one embodiment, the electrical switching is coupled to the electrical terminal.

In one embodiment, at least one superconducting sheet comprises a stack of bonded layers comprising at least the superconducting layer, the superconducting layer being a layer of a superconducting material or a material adapted to be superconducting under appropriate conditions like under a temperature limit, for example a rare-earth based material, like a rare-earth barium copper oxide, or an yttrium barium copper oxide.

In one embodiment, the stack further comprises:
- a structural layer located at or near a second surface opposite to the first surface of the superconducting sheet, the structural layer being for example composed or covered by a material like Hastelloy;
- at least a buffer layer, preferably a plurality of buffer layers, between the structural layer and the superconducting layer;
wherein the groove of the at least one superconducting sheet is patterned in the at least one buffer layer and the superconducting layer.

In one embodiment, the groove is filled with air, a metal like silver, a ceramic material or a cooling agent adapted to cool the at least one superconducting sheet.

In one embodiment, the space-filling curve pattern of at least one superconductive sheet follows a fractal geometry, a square spiral geometry, or a serpentine geometry.

In one embodiment, the first surface of at least one superconducting sheet comprises a plurality of regions isolated from each other, for example by means of a furrow, each region having a groove extending from said first surface, the pattern of the groove being a space-filling curve.

In one or several particular embodiments:
- the space-filling curve patterns of at least two regions are different; and/or
- the position and/or the number of the at least one electrode of at least two regions are different.

In one embodiment, the at least one superconducting sheet is cylindrically folded.

### Advantages

Advantages of the superconducting energy storage device according to one or more aspects are as follows: it is capable of storing energy for a very long time. If the operating conditions are kept constant and proper maintenance is observed, then energy can be stored indefinitely, or at least for a very long time, defeating other devices which are currently available on the market in product lifespan. Its inductors produce no magnetic field from a close distance from the surface. It is capable of storing energy in an electromagnetic field, but because of the geometries employed in the construction of the inductor, the magnetic field is negligible, except very close to the surface. This overcomes a limitation of devices shown in the prior art by allowing the field to more rapidly decay away from the surface, hence providing more safety. The superconducting energy storage device can be charged much faster than other devices. Other advantages become apparent from the detailed description and drawings.

### Brief description of drawings

The foregoing features and advantages, as well as others, will be described in detail in the following description of specific embodiments given by way of illustration and not limitation with reference to the accompanying drawings, in which:
FIG. 1 is a general perspective view of an embodiment of the disclosed superconducting energy storage device.
FIG. 2 is a general perspective view of a superconducting sheet in an embodiment of the superconducting energy storage device of FIG. 1.
FIG. 3 is an enlarged perspective view of a cross section of a superconducting sheet in an embodiment of the disclosed superconducting energy storage device.
FIG. 4 is an exploded perspective view of the interior of a container featured in an embodiment of the superconducting energy storage device of FIG. 1.
FIG. 5 is a block diagram describing a connection scheme for the main electrical components in an embodiment of the disclosed superconducting energy storage device.
FIG. 6 is a general perspective view of a sectioned superconducting sheet in another embodiment of the disclosed superconducting energy storage device.
FIG. 7 is a general perspective view of a superconducting sheet in another embodiment of the disclosed superconducting energy storage device.
FIGS. 8A to 17D are different space-filling curves.

### Reference numerals

1: superconducting sheet
2: rack
5: container
6: cooling agent
7: electrical terminal
502: servicing device
504: pressure relief valve
104: groove
102: electrode
300: stack
301: structural layer
303: first buffer layer
305: second buffer layer
307: third buffer layer
308: fourth buffer layer
309: superconducting layer
116: first surface
117: second surface
220: structural elements
222: holding elements
1a-1e: each of the different superconducting sheets
102La-102Le: each of the left (first) electrodes of a superconducting sheet
102Ra-102Re: each of the right (second) electrodes of a superconducting sheet
205: common connection point
206: cable
9: electrical switching device
8: load
701: switch
120: sectioned superconducting sheet
121: region (surface region)
124: sectioned groove
122: sectioned electrodes
126: furrow
128: first surface (top surface)
130: cylindrically-folded superconducting sheet

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

The following figures are not to scale. It should be noted that the drawings refer to an embodiment of the disclosed superconducting energy storage device, sometimes also referred simply as device, when no ambiguity in the text is anticipated. Other embodiments may be possible, and some are described in the figures as well. The actual dimension and/or shape of each of the components of the embodiment may vary. Only important details of the embodiment are shown, however one of ordinary skill in the art can appreciate how the overall device may be constructed, without undue experimentation. Some details have been omitted from the drawings, but the inventors believe that adding these details is unnecessary for the overall appreciation of the characteristics of the invention disclosed. Some characteristics of the embodiment appear exaggerated to facilitate understanding. The embodiments disclosed, and alternatives observed should not be considered as limiting the invention in any way.

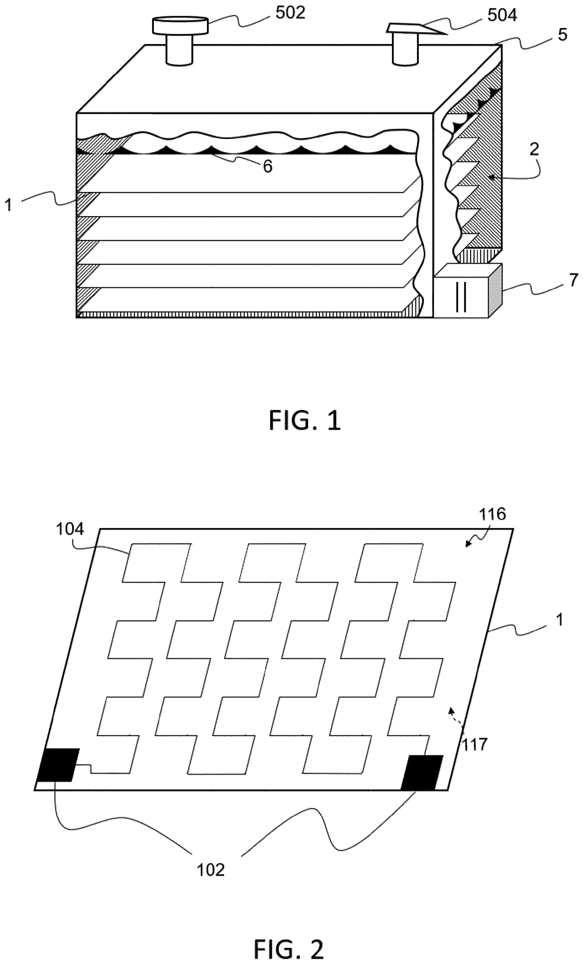

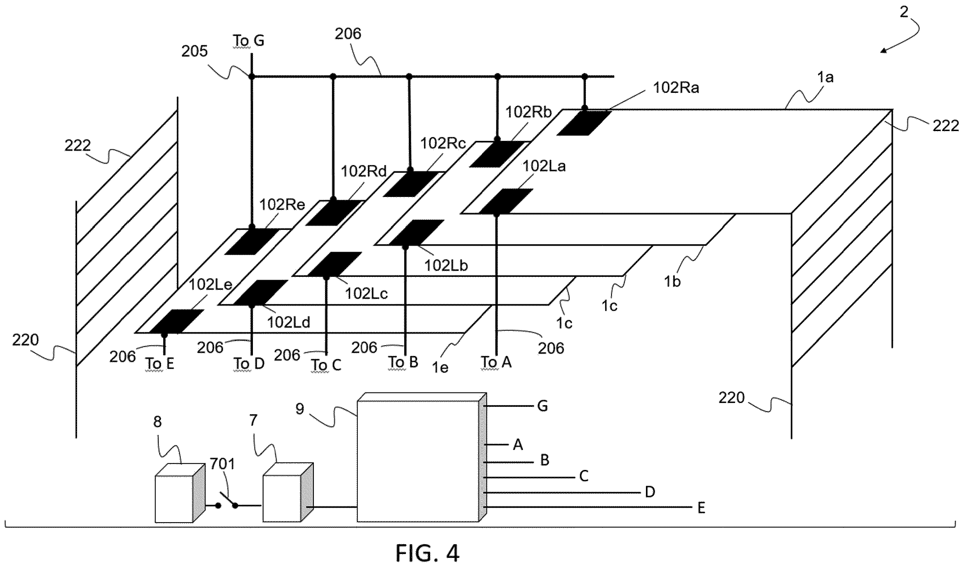

A first embodiment of a device is shown in FIG. 1. This drawing of FIG. 1 has omitted certain characteristics of a rack, a component of the embodiment. Some of the omitted characteristics are shown in detail in FIG. 4.

In the first embodiment, a container **5,** filled with a cooling agent **6,** houses a rack **2.** The rack **2** holds, mechanically or by other appropriate means, a plurality of superconducting sheets **1.** In addition, an electrical terminal **7** is attached to the container **5.** The container **5** may be thermally insulated, for example a dewar. Further, the container **5** may comprise a servicing device **502** to service the cooling agent **6,** and a pressure relief valve **504.** The cooling agent **6** is a substance with heat transfer properties which allow for cooling of, for example, the superconducting sheet **1.** Preferably the cooling agent **6** may be liquid nitrogen (LN₂), helium (He) or another substance kept at temperatures that sustain the superconducting properties of the superconducting sheet **1.** The relief valve **504** may be provided to relief pressure buildup inside the container **5** and prevent malfunction. It should be noted that the superconducting sheets **1** shown in FIG. 1 are all equal to the one shown in FIG. 2, and hence are numbered the same, although the illustration of the sheet **1** in FIG. 1 does not show the groove **104** shown in FIG. 2. The groove **104** has been omitted from FIG. 1 to make this drawing easier to understand.

The servicing device **502** may be located on a surface of the container **5,** this servicing device **502** accommodates for servicing the cooling agent **6.** In one embodiment the servicing device **502** should be taken to mean a hatch, opening, lever or otherwise another device with the function of allowing a user to access the cooling agent **6** and replace it, or in another way sustain its proper operation. This should not be limiting on the servicing device **502,** for example in an embodiment where the cooling agent **6** is LN₂, the servicing device **502** may be constituted as a hatch positioned so that liquid nitrogen is expulsed and replaced. In another embodiment, where helium gas is used as a cooling agent **6,** the servicing device **502** would describe a nozzle where to connect a recirculation circuit for the helium gas.

The superconducting sheet **1** is described in greater detail in FIG. 2. The superconducting sheet **1** has a first surface **116** and a second surface **117,** and a groove **104** over the first surface **116.** The groove **104** separates the superconducting sheet into different electrically conductive regions. The groove **104** describes a pattern characterized for being a space-filling curve. Furthermore, this superconducting sheet **1** is also furnished by a plurality of electrodes **102.** The first embodiment is comprised of two electrodes **102** at different locations over the first surface **116** of the superconducting sheet **1,** although it should be noted that other embodiments may have more electrodes **102** and that embodiments may have electrodes at different positions. Each end of the space-filling curve described by the groove **104** terminates at an electrode **102.**

In the first embodiment, the superconducting sheet **1** from FIG. 2 may be constructed as a chemically or otherwise bonded stack **300** of several layers of different materials.

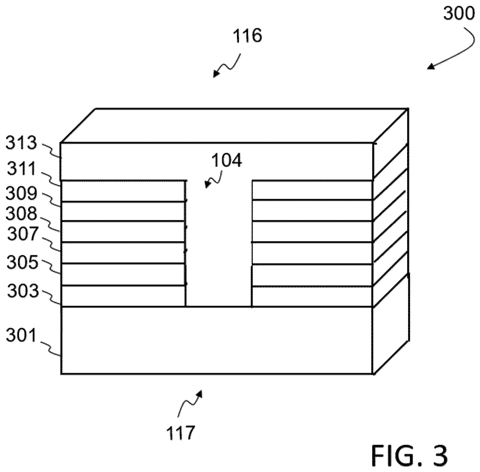

An example of stack **300** comprising several layers is shown in FIG. 3 from the second surface **117** to the first surface **116** of the superconducting sheet **1.**

The stack comprises a structural layer **301,** which may be composed or covered by a material like Hastelloy.

At least a buffer layer, for example several buffer layers may be deposited, for example sputtered, on the first structural layer **301.**

The buffer layer(s) may be constructed from material(s) that allows high in plane orientation of the superconducting layer **309** described after, for example to form an appropriate template for the formation of said superconducting layer.

As illustrated in the stack of FIG. 3, the buffer layers may comprise:
- a first buffer layer **303** of a material like alumina (Al₂O₃);
- a second buffer layer **305** of a material like yttria;
- a third buffer layer **307** of a material like magnesium oxide (MgO) ;
- a fourth buffer layer **308** of a material like lanthanum manganite (LMO).

A superconducting layer **309** is deposited, for example using MOCVD, on the fourth buffer layer **308.**

The superconducting layer **309** may be constructed from a superconducting material or a material that may become superconducting under the appropriate conditions, conditions which may include operating at or above the temperature of liquid nitrogen, about 77K. In an embodiment, the superconducting layer **309** is constructed from rare-earth (RE) based superconductors such as REBa₂Cu₃O_{7-δ} or REBa₂Cu₄O₈, these superconductors or those with similar composition formulas are also known as REBCO. The superconducting layer **309** may also be constructed from yttrium-based superconductors collectively known as YBCO and with composition formulas such as YBa₂Cu₃O_{7-δ} or YBa₂Cu₄O₈.

The layers above the substrate layer **301,** that is, the first buffer layer **303,** the second buffer layer **305,** the third buffer layer **307,** the fourth buffer layer **308** and the superconducting layer **309,** may have some of their material removed, without destruction to the overall shape of the superconducting sheet **1** from FIG. 2. The removal of material results in a cavity identified as the groove **104** in FIG. 3, that can also be seen in FIG. 2, that describes the pattern characterized as a space-filling curve in the first surface **116** of the superconducting sheet **1.** Techniques used for removal of the material may include laser patterning. Other techniques, like a mechanical technique or photolithography may be used.

Before forming the groove **104,** the described sequence of buffer and superconducting layers may be repeated several times to form a repeater layer **311,** with best results being achieved between 4 and 80 repetitions of the layer sequence, for example between 20 and 40 repetitions of the layer sequence for magnetic fields of about 10 Tesla. The groove **104** may also be formed in the repeater layer **311.**

In the first embodiment, the cavity that forms the groove **104** may be filled by the cooling agent **6** (from FIG. 1) but it may also be filled by other substances (layer **313**). For instance, the cavity could be filled with air, a metal like Ag or ceramic compounds.

It should be noted that anyone with proficiency in the technique may be capable of achieving the same functionality with a different number of layers, by a different stacking orientation, or even by replacing or changing the order of the layers that have been presented in the first embodiment.

Other appropriate materials, other layer configurations and/or methods for constructing a superconducting sheet, as a stacked layer of different materials should be apparent to anyone with ordinary skill in the art. Another example is given in European patent application number EP22305437, filed on April 4, 2022 by the same applicant "RENAISSANCE FUSION", entitled "METHOD FOR MANUFACTURING SUPERCONDUCTING COILS AND DEVICE", which is hereby incorporated by reference to the maximum extent allowable by law. The superconducting sheet may then be constructed similarly to the modular coil.

The interior of the container **5** from FIG. 1 is exploded in FIG. 4. In this exploded view, the rack **2** is comprised of a pair of structural elements **220,** each sustaining a plurality of holding elements **222;** each holding element **222** supports a different superconducting sheet **1a-1e.** As the rack **2** is submerged in a cooling agent **6,** there must be enough space in between each sheet **1a-1e** to allow the cooling agent to contact at least the first surface of each sheet **1a-1e.** The superconducting sheets **1a-1e** may be constructed in a similar manner to the superconducting sheet **1** from FIG. 2. Each superconducting sheet **1a-1e** may be formed out of a stack **300** as the one shown in FIG. 3. Each superconducting sheet **1a-1e** has a groove that defines a pattern of a space-filling curve, like the groove **104** from FIG. 2. It should be noted that in FIG. 4, the groove is not shown for better understanding of the figure.

In addition, each superconducting sheet **1a-1e** has a pair of electrodes **102La-102Le** (left, or first, electrodes), **102Ra-102Re** (right, or second, electrodes). In this embodiment, a first superconducting sheet **1a** has a left electrode **102La** and a right electrode **102Ra,** the second superconducting sheet **1b** also has a left electrode **102Lb** and a right electrode **102Rb,** and so on with the other superconducting sheets **1c-1e.** The right electrode **102Ra** of the first superconducting sheet **1a** is connected to the right electrode **102Rb** of the second superconducting sheet **1b** and so on, so that all the right electrodes **102Ra-102Re** are connected to each other, forming a common connection point **205.** This connection may be realized by a cable **206** or by another appropriate connection method. The common connection point **205** is then connected to an electrical switching device **9.**

The electrical switching device **9** is a common electrical component with the functionality of establishing a selective connection between the energy source and each of the superconducting sheets **1a-1e.** The electrical switching device **9** by following a digital, mechanical or electrical control rule determines which connection to establish. For instance, the electrical switching device **9** may establish a connection between the first superconducting sheet **1a** and between a load **8** so that the energy stored in the first sheet **1a** is transferred to the load **8.** Other common electrical components may also be needed to accomplish the described functionality.

The left electrode **102La** of the first superconducting sheet **1a** is connected to the electrical switching device **9.** The other left electrodes **102Lb-102Le** of the other superconducting sheets **1b-1e** are also connected to the electrical switching device **9,** also by cables **206,** or another appropriate connection method. It should be noted that many other connection schemes are possible, for example, a connection scheme that is described as parallel or one that may be described as a series connection may also be possible; connections that are partly parallel and partly series connections are also possible. The electrical switching device **9** is then connected to the electrical terminal **7,** which is also shown in FIG. 1. During operation, the electrical terminal **7,** is then connected to a load **8,** through a switch **701.**

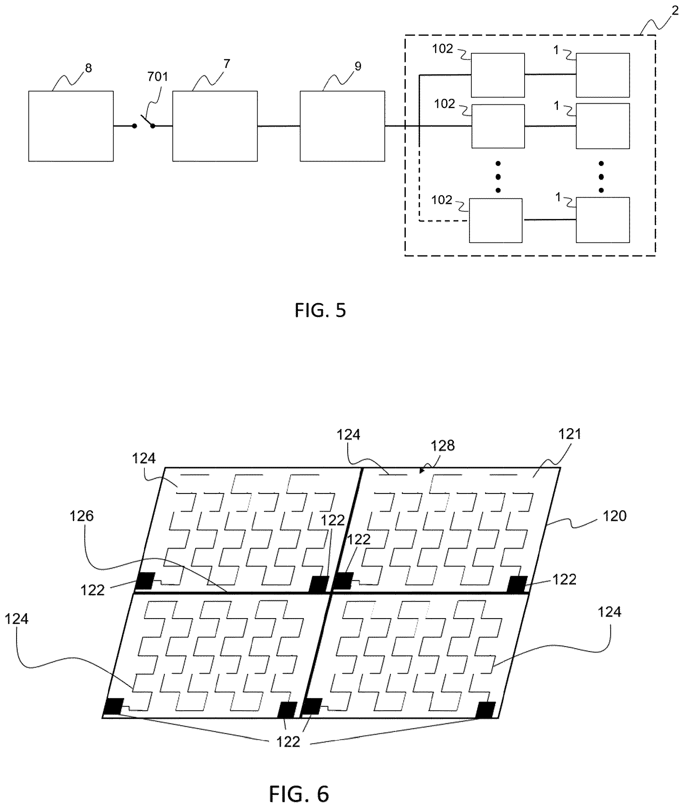

FIG. 5 is a block diagram describing the connection scheme for the main electrical components in the first embodiment. A plurality of superconducting sheets **1** mechanically sustained in the rack **2** are connected through their respective electrodes **102** to the electrical switching device **9.** The electrical switching device **9** is then connected to the electrical terminal **7.** The electrical terminal **7** is connected to a switch **701,** or another apparatus to the same end, which may then be connected to a load **8.** It is also possible to electrically charge the superconducting energy storage device described in the first embodiment by connecting the electrical terminal **7** through the switch **701** to an energy source.

As can be seen in FIG. 2, the superconducting sheet **1** comprises a groove **104.** The groove **104** describes a pattern over the first surface **116** of the superconducting sheet **1.** This pattern is characterized by having the properties of a space-filling curve. Fractals are an example of space-filling curves, although other geometries may be possible. Space-filling curves are curves that cover a surface area. The longer the curve is, the more surface area is covered.

Space-filling curves, in specific fractals, are geometries with the properties of self-similarity. Fractals have been used in industrial applications from at least the 1990s. For example, in U.S. Pat. No. 7,541,981 to Piskun, a fractal geometry described as Peano-Gosper curve, is used to construct an antenna with novel properties. Small scale electrical components such as capacitors and inductors have also been constructed with space-filling curves as described in N. Lazarus, C. D. Meyer and S. S. Bedair, "Fractal Inductors," in IEEE Transactions on Magnetics, vol. 50, no. 4, pp. 1-8, April 2014, Art no. 8400708, doi: 10.1109/TMAG.2013.2290510. Lazarus defines a space filling curve as a trace that, in the limit, fills every point in a bounded area. Lazarus also describes a number of space-filling curves that are well known in the field of mathematics.

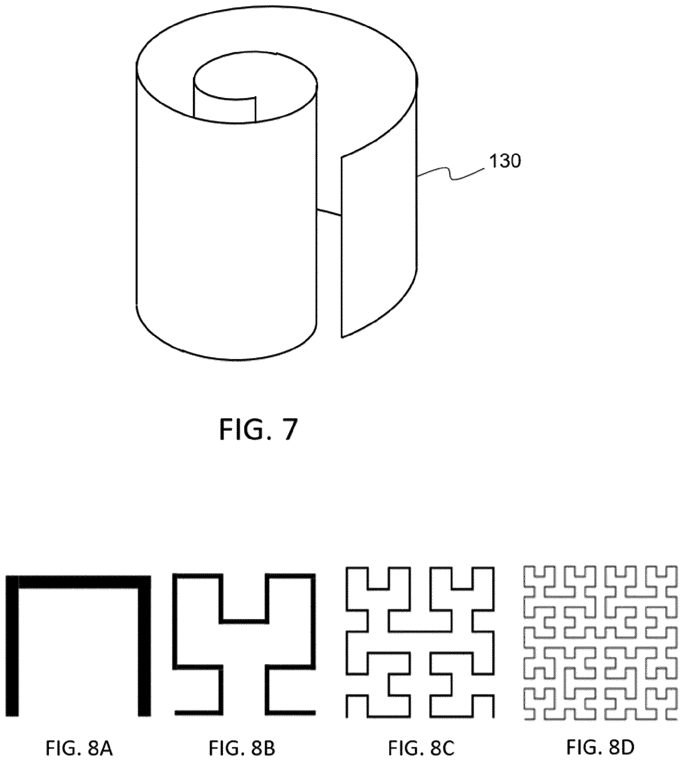

Several space-filling curves have been reproduced in FIGs. 8A to 17D. To reproduce these shapes over the first surface **116** of a superconducting sheet **1,** a person skilled in the art would have to follow the generating steps of the specific curve to reproduce. In general, space-filling curves have a single zeroth step and at least two additional steps known as the first step and the second step.

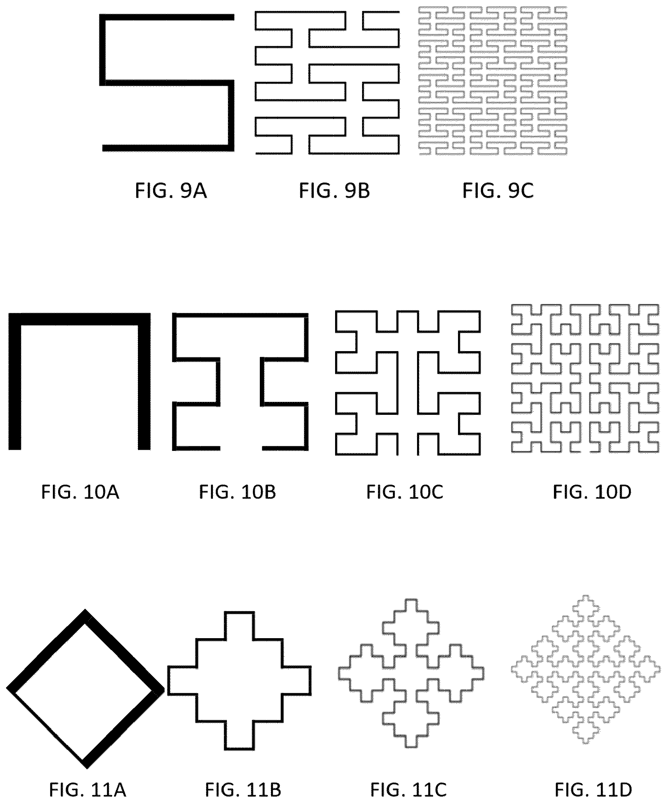

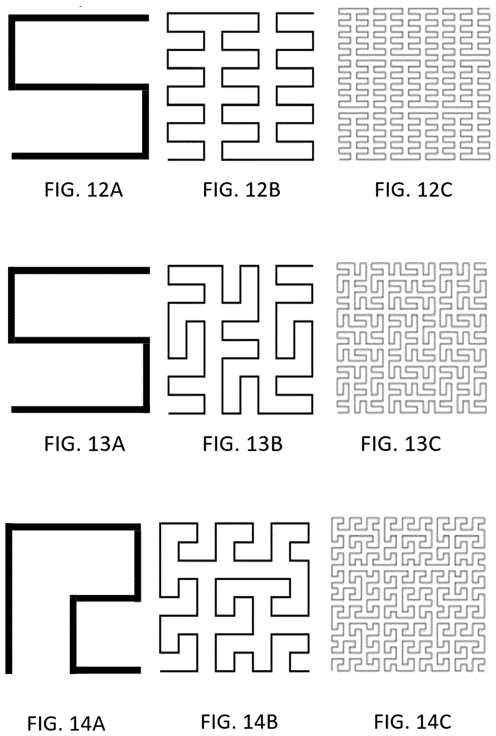

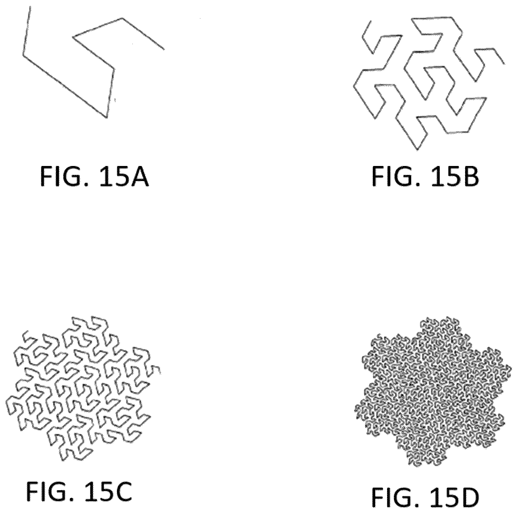

To construct a space-filling curve from a fractal geometry one is to start in the zeroth step and draw it over a surface. For example, the zeroth step of the Hilbert curve or the Moore curve is an inverted letter u, and that of the Peano curve or the Luxberg curves is a letter s. Generative steps of the above-cited curves and some other curves are shown in: FIG. 8A, Hilbert; FIG. 9A, Peano; FIG. 10A, Moore; FIG. 11A, Sierpinski; FIG. 12A, Luxberg I; FIG. 13A, Luxberg II; FIG. 14A, R curve and FIG. 15A, Peano-Gosper.

The first step is realized by dividing the surface where the zeroth step was drawn and dividing it into four quadrants. Then the zeroth step is drawn again in each of these quadrants. Some of the drawn shapes are rotated, then excesses are cleaned, and ends are connected. In the case of the Hilbert curve, this resulting first step is shown in FIG. 8B. The first step of other curves is shown in: FIG. 9B, Peano; FIG. 10B, Moore; FIG. 11B, Sierpinski; FIG. 12B, Luxberg I; FIG. 13B, Luxberg II; FIG. 14B, R curve and FIG. 15B, Peano-Gosper.

The second step is realized by again dividing the surface area where the first step was constructed into four regions. In each region, the first step is drawn again. Of the resulting four copies of the first step some are rotated, excess lines are eliminated, and then they are all connected. For the Hilbert curve, this results in the curve shown in FIG. 8C. Other second steps are shown in: FIG. 9C, Peano; FIG. 10C, Moore; FIG. 11C, Sierpinski; FIG. 12C, Luxberg I; FIG. 13C, Luxberg II; FIG. 14B, R curve and FIG. 15C, Peano-Gosper.

This can now be continued for as many times as space allows. With the generating process for each step following the one described. The third step of the Hilbert curve is shown in FIG. 8D. The third step of other curves are shown in: FIG. 10D, Moore; FIG. 11D, Sierpinski; and FIG. 15D, Peano-Gosper. In an embodiment, the space-filling curve could be such so that the size of the shape of the zeroth step in the pattern shares order of magnitude with the width of the groove **104** (from FIG. 2).

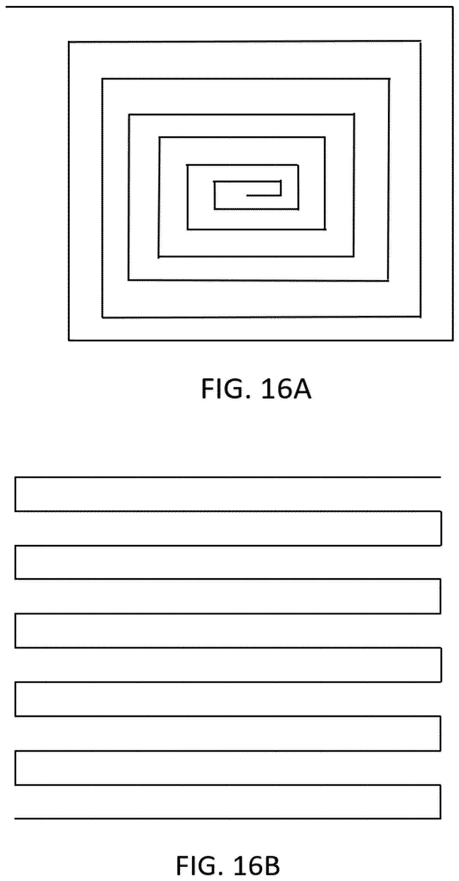

It should be understood that the space-filling curves described here are not limiting. Embodiments with curves that do not follow fractal geometries or that are not represented by generating steps with 2-dimensional shapes are also possible. To illustrate this, the square spiral geometry of FIG. 16A is shown. The square spiral may be constructed following other steps than the ones described above yet, it is still a curve that can fill the entire surface and is still identified as a space-filling curve. Similarly, the serpentine depicted in FIG. 16B is still a curve that can fill the entire surface and is still identified as a space-filling curve.

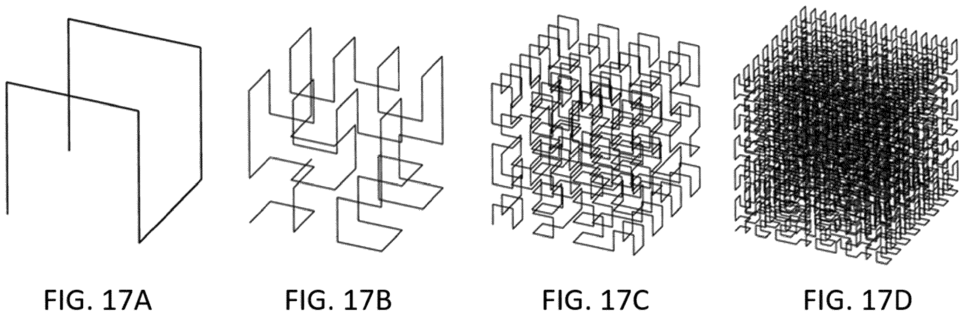

Further, space filling curves may also be constructed to fill a volume, such as the Peano-Hilbert 3D space filling curve shown in FIG. 17D. The curve in FIG. 17D is also formed from a zeroth step shown in FIG. 17A, this is then replicated in space, turned, and connected forming a first step shown in FIG. 17B. A second step is shown in FIG. 17C. In an embodiment, the lines of the curves are constructed in a manner analogous to the superconducting sheet **1** from FIG. 2, where the sheets are bended, cut and folded to achieve the appropriate shape.

### Example of operation

According to the first embodiment, the superconducting energy storage device may be operated in a charge or discharge mode, according to the load **8** connected to the electrical terminal **7,** as shown in FIG. 5. When there is energy stored in the superconducting energy storage device, a load **8** may be connected to it, and the energy stored in the device would be transferred to the load **8** when the switch **701** is closed (discharge mode). In the charge mode, the device is void of charge, no energy is stored in it, and, in place of a load, an energy source is connected to the terminal **7,** once the switch **701** is closed, energy is transferred from the energy source to the device.

In the charge mode, energy is transferred to the device through an electrical potential. When an energy source is connected to the electrical terminal **7,** and the switch **701** is closed, a connection between the energy source and the electrical switching device **9** is formed. Before the connection is established, the superconducting sheets **1a-1e** have no energy stored. When the energy source is connected, the electrical switching device **9** establishes a connection between the first sheet **1a** and the energy source. As this is done through an electrical potential, this results in a current on the superconducting sheet **1a**. Because the superconducting sheet **1a** is formed with a superconducting layer **309** (FIG. 3), current flows without resistance through this layer.

The current follows the path of the space-filling curve pattern described by the groove **104** (FIG. 2). The geometry of the current path results in an inductor configuration, which stores the energy from the energy source in a magnetic field. An embodiment of this configuration has current in a path that continually changes direction. This creates a magnetic field that change directions and are negligible at a close distance from the first surface **116** of the superconducting sheet. The magnetic field may be negligible at a distance comparable with the period over which the current (and thus the magnetic field) changes direction. For example, if that period is 1 mm, the magnetic field is negligible at a distance of several millimeters.

Once the first superconducting sheet **1a** is charged, the electrical switching device **9** disconnects the first superconducting sheet **1a** and establishes a connection with the second superconducting sheet **1b**. This process is repeated until all sheets **1a-1e** are charged.

During the discharge mode, a load **8** is connected to the electrical terminal **7,** through the switch **701.** In this mode, the superconducting sheets **1a-1e** are charged or partially charged, so there is energy stored in the device. Considering that all sheets **1a-1e** are charged, the superconducting energy device is going to transfer energy to the load **8.** When the load **8** is connected and the switch **701** is closed, the electric switching device **9** establishes a connection between the first superconducting sheet **1a** and the load **8.** As the circuit closes, the electric potential established by the magnetic field results in a current flow; energy is therefore consumed by the load **8.** Once the first superconducting sheet **1a** is completely discharged, the electrical switching device **9** disconnects the sheet **1a** and establishes a connection between the second superconducting sheet **1b** and the load **8.**

The modes of operation are not limiting, neither is the operation of the electric switching device **9.** It should be apparent to someone skilled in the art that there are different electrical connection schemes as well as other switching schemes that achieve the same functionality, so that other embodiments or alternatives are possible.

### Additional Embodiments

In a second embodiment of the superconducting energy storage device, a sectioned superconducting sheet **120,** shown in FIG. 6, may be constructed in an analogous manner to the superconducting sheet **1** of FIG. 2. The first surface **128** of the sectioned sheet **120** is divided into a plurality of regions **121.** Each surface region **121** is electrically isolated from any of the others, for example by a furrow **126.** Further, each region **121** is comprised of a groove **124** that describes a space-filling curve and a plurality of electrodes **122.** In this embodiment, the space-filling curve patterns that are described by each of the grooves **124** may be different in each region **121.** The positions and number of the electrodes **122** may also differ in each region **121.** The furrow **126** and groove **124** in this embodiment may be constructed in a manner analogous to the groove **104** from FIG 3.

In a third embodiment, the superconducting energy storage device comprises a cylindrically-folded superconducting sheet **130,** shown in FIG. 7. The cylindrically-folded sheet **130** is constructed in the same manner as the superconducting sheet **1** from FIG. 2; and may also include electrodes and a groove, like the electrode **102** and groove **104** from FIG. 1. A plurality of cylindrically folded superconducting sheets **130,** may then be housed in a container like the container **5** from FIG. 1, and this container may now be shaped like a cylinder. In a similar manner, a rack, like the rack **2** from FIG. 2, is now constructed to accommodate cylindrically-folded sheets **130.** The shapes and placements of other components required for the proper operation of the device in this embodiment may then be inferred.

Example embodiments of the invention are summarized here. Other embodiments can also be understood from the entirety of the specification as well as the claims filed herein.

Example 1. An energy storage device comprising:
- at least one superconducting sheet (1; 1a-1e; 120; 130) adapted to be coupled to a load (8) in a discharge mode and/or to an energy source in a charge mode, wherein each superconducting sheet comprises a superconducting layer (309), and at least a groove (104; 124) extending from a first surface (116; 128) of said superconducting sheet into at least the superconducting layer (309), the pattern of the groove being a space-filling curve; and
- at least one electrode (102; 102La-102Le; 102Ra-102Ra; 122), preferably two electrodes, for each superconducting sheet, the at least one electrode being coupled to the groove of said superconducting sheet, for example one electrode at each end of the space-filling curve pattern of the groove.

Example 2. The device according to example 1, further comprising a cooling agent (6) adapted to cool the at least one superconducting sheet, the cooling agent being for example liquid nitrogen or helium.

Example 3. The device according to example 1 or 2, further comprising an electrical terminal (7) adapted to couple the at least one superconducting sheet through the at least one electrode to a load (8) and/or to an energy source, for example using a switch (701).

Example 4. The device according to any one of examples 1 to 3, further comprising:
- a rack (2) adapted to hold the at least one superconducting sheet, for example by means of at least one holding element (222) sustained by a structural element (220), each holding element being adapted to support a superconducting sheet; and
- a container (5) adapted to house the rack (2), the container being adapted to be thermally insulated; and, possibly
- a servicing device (502) adapted to servicing a cooling agent (6), the servicing device being for example located on a surface of the container; and/or
- a pressure relief valve (504), for example located on a surface of the container.

Example 5. The device according to any one of examples 1 to 4, comprising a plurality of superconducting sheets (1), wherein the at least one electrode (102) is coupled to an electrical switching device (9) using a series and/or parallel connection.

Example 6. The device according to any one of examples 1 to 5, comprising a plurality of superconducting sheets (1a-1e), wherein the at least one electrode for each superconducting sheet comprises a first electrode (102La-102Le) and a second electrode (102Ra-102Ra), for example the first electrode at a first end and the second electrode at a second end of the space-filling curve pattern of the groove (104) of said each superconducting sheet.

Example 7. The device according to example 6 in combination with example 5, wherein the first electrodes (102La-102Le) of the plurality of superconducting sheets are coupled in parallel to the electrical switching device (9), and the second electrodes (102Ra-102Ra) of the plurality of superconducting sheets are coupled in series to a common connection point (205) which is coupled to the electrical switching device (9).

Example 8. The device according to example 5 or 7 in combination with example 3, wherein the electrical switching (9) is coupled to the electrical terminal (7).

Example 9. The device according to any one of examples 1 to 8, wherein at least one superconducting sheet comprises a stack (300) of bonded layers comprising at least the superconducting layer (309), the superconducting layer (309) being a layer of a superconducting material or a material adapted to be superconducting under appropriate conditions like under a temperature limit, for example a rare-earth based material, like a rare-earth barium copper oxide, or an yttrium barium copper oxide.

Example 10. The device according to example 9, wherein the stack further comprises:
- a structural layer (301) located at or near a second surface (117) opposite to the first surface (116) of the superconducting sheet, the structural layer being for example composed or covered by a material like Hastelloy;
- at least a buffer layer, preferably a plurality of buffer layers (303, 305, 307, 308), between the structural layer (301) and the superconducting layer (309);
wherein the groove (104) of the at least one superconducting sheet is patterned in the at least one buffer layer and the superconducting layer.

Example 11. The device according to example 10, wherein the at least one buffer layer comprises:
- a first buffer layer (303) on the structural layer, for example a layer of a material like alumina;
- a second buffer layer (305) on the first buffer layer, for example a layer of a material like yttria;
- a third buffer layer (307) on the second layer, for example a layer of a material like magnesium oxide; and
- a fourth buffer layer (308) on the third layer, for example a layer of a material like lanthanum manganite.

Example 12. The device according to any one of examples 1 to 11, wherein the groove (104) is filled with air, a metal like silver, a ceramic material or a cooling agent (6) adapted to cool the at least one superconducting sheet.

Example 13. The device according to any one of examples 1 to 12, wherein the space-filling curve pattern of at least a superconductive sheet follows a fractal geometry, a square spiral geometry, or a serpentine geometry.

Example 14. The device according to any one of examples 1 to 13, wherein, in the charge mode, a current follows the path of the space-filling curve pattern of the at least one superconductive sheet, resulting in an inductor configuration adapted to store energy in a magnetic field.

Example 15. The device according to example 14, wherein the path is adapted to make the current continually changing direction so that the magnetic field changes direction and is negligible at a short distance from the first surface of the at least one superconducting sheet.

Example 16. The device according to any one of examples 1 to 15, wherein the first surface (128) of at least a superconducting sheet (120) comprises a plurality of regions (121) isolated from each other, for example by means of a furrow (126), each region having a groove (124) extending from said first surface, the pattern of the groove being a space-filling curve.

Example 17. The device according to example 16, wherein:
- the space-filling curve patterns of at least two regions (121) are different; and/or
- the position and/or the number of the at least one electrode (122) of at least two regions (121) are different.

Example 18. The device according to any one of examples 1 to 17, wherein the at least one superconducting sheet (130) is cylindrically folded.

Example 19. The device according to example 18, comprising a cylindrical container adapted to house the at least one cylindrically folded superconducting sheet (130).

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

### List of acronyms:

- SMES: Superconducting Magnetic Energy Storage
- LN₂: Liquid Nitrogen
- Ag: Silver
- Cu: Copper
- Ba: Barium
- O: Oxygen
- Al₂O₃: Aluminum Oxide (alumina)
- LMO: Lanthanum manganite
- MgO: Magnesium Oxide (magnesia)
- RE: Rare earth
- REBCO: Rare-earth barium copper oxide
- YBCO: Yttrium barium copper oxide
- MOCVD: Metal-organic chemical vapor deposition

## Claims

1. An energy storage device comprising:
- at least one superconducting sheet (1; 1a-1e; 120; 130) adapted to be coupled to a load (8) in a discharge mode and/or to an energy source in a charge mode, wherein each superconducting sheet comprises a superconducting layer (309), and at least a groove (104; 124) extending from a first surface (116; 128) of said superconducting sheet into at least the superconducting layer (309), the pattern of the groove being a space-filling curve; and
- at least one electrode (102; 102La-102Le; 102Ra-102Ra; 122), preferably two electrodes, for each superconducting sheet, the at least one electrode being coupled to the groove of said superconducting sheet, for example one electrode at each end of the space-filling curve pattern of the groove.

2. The device according to claim 1, further comprising a cooling agent (6) adapted to cool the at least one superconducting sheet, the cooling agent being for example liquid nitrogen or helium.

3. The device according to claim 1 or 2, further comprising an electrical terminal (7) adapted to couple the at least one superconducting sheet through the at least one electrode to a load (8) and/or to an energy source, for example using a switch (701).

4. The device according to any one of claims 1 to 3, further comprising:
- a rack (2) adapted to hold the at least one superconducting sheet, for example by means of at least one holding element (222) sustained by a structural element (220), each holding element being adapted to support a superconducting sheet; and
- a container (5) adapted to house the rack (2), the container being adapted to be thermally insulated; and, possibly,
- a servicing device (502) adapted to servicing a cooling agent (6), the servicing device being for example located on a surface of the container; and/or
- a pressure relief valve (504), for example located on a surface of the container.

5. The device according to any one of claims 1 to 4, comprising a plurality of superconducting sheets (1), wherein the at least one electrode (102) is coupled to an electrical switching device (9) using a series and/or parallel connection.

6. The device according to any one of claims 1 to 5, comprising a plurality of superconducting sheets (1a-1e), wherein the at least one electrode for each superconducting sheet comprises a first electrode (102La-102Le) and a second electrode (102Ra-102Ra), for example the first electrode at a first end and the second electrode at a second end of the space-filling curve pattern of the groove (104) of said each superconducting sheet.

7. The device according to claim 6 in combination with claim 5, wherein the first electrodes (102La-102Le) of the plurality of superconducting sheets are coupled in parallel to the electrical switching device (9), and the second electrodes (102Ra-102Ra) of the plurality of superconducting sheets are coupled in series to a common connection point (205) which is coupled to the electrical switching device (9).

8. The device according to claim 5 or 7 in combination with claim 3, wherein the electrical switching (9) is coupled to the electrical terminal (7).

9. The device according to any one of claims 1 to 8, wherein at least one superconducting sheet comprises a stack (300) of bonded layers comprising at least the superconducting layer (309), the superconducting layer (309) being a layer of a superconducting material or a material adapted to be superconducting under appropriate conditions like under a temperature limit, for example a rare-earth based material, like a rare-earth barium copper oxide, or an yttrium barium copper oxide.

10. The device according to claim 9, wherein the stack further comprises:
- a structural layer (301) located at or near a second surface (117) opposite to the first surface (116) of the superconducting sheet, the structural layer being for example composed or covered by a material like Hastelloy;
- at least a buffer layer, preferably a plurality of buffer layers (303, 305, 307, 308), between the structural layer (301) and the superconducting layer (309);
wherein the groove (104) of the at least one superconducting sheet is patterned in the at least one buffer layer and the superconducting layer.

11. The device according to any one of claims 1 to 10, wherein the groove (104) is filled with air, a metal like silver, a ceramic material or a cooling agent (6) adapted to cool the at least one superconducting sheet.

12. The device according to any one of claims 1 to 11, wherein the space-filling curve pattern of at least a superconductive sheet follows a fractal geometry, a square spiral geometry, or a serpentine geometry.

13. The device according to any one of claims 1 to 12, wherein the first surface (128) of at least a superconducting sheet (120) comprises a plurality of regions (121) isolated from each other, for example by means of a furrow (126), each region having a groove (124) extending from said first surface, the pattern of the groove being a space-filling curve.

14. The device according to claim 13, wherein:
- the space-filling curve patterns of at least two regions (121) are different; and/or
- the position and/or the number of the at least one electrode (122) of at least two regions (121) are different.

15. The device according to any one of claims 1 to 14, wherein the at least one superconducting sheet (130) is cylindrically folded.
